(19) **Europäisches Patentamt** / **European Patent Office** / **Office européen des brevets**

(11) **EP 2 100 170 B1**

(12) **FASCICULE DE BREVET EUROPEEN**

(45) Date de publication et mention de la délivrance du brevet:
**06.07.2011 Bulletin 2011/27**

(21) Numéro de dépôt: **07847225.5**

(22) Date de dépôt: **20.11.2007**

(51) Int Cl.:
**G02B 1/11** (2006.01)   **H01S 5/028** (2006.01)

(86) Numéro de dépôt international:
**PCT/EP2007/062549**

(87) Numéro de publication internationale:
**WO 2008/071518 (19.06.2008 Gazette 2008/25)**

(54) **AMPLIFICATEUR LASER A CASCADES QUANTIQUES EQUIPE D'UN REVETEMENT ANTI-REFLECHISSANT COMPORTANT UNE STRATE REALISEE EN FLUORURE D'YTTRIUM**

QUANTISCHER KASKADENLASERVERSTÄRKER MIT ANTIREFLEXBESCHICHTUNG MIT EINER SCHICHT AUS YTTRIUMFLUORID

QUANTUM CASCADE LASER AMPLIFIER WITH AN ANTI-REFLECTION COATING INCLUDING A LAYER OF YTTRIUM FLUORIDE

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **11.12.2006 EP 06125845**

(43) Date de publication de la demande:
**16.09.2009 Bulletin 2009/38**

(73) Titulaire: **Alpes Lasers S.A.**
**2000 Neuchâtel (CH)**

(72) Inventeurs:
• **MAULINI, Richard**
**Los Angeles CA 900 25 (US)**
• **BLASER, Stéphane**
**2046 Fontaines (CH)**
• **FAIST, Jérôme**
**2072 St-Blaise (CH)**

(74) Mandataire: **GLN**
**Rue du Puits-Godet 8a**
**2000 Neuchâtel (CH)**

(56) Documents cités:
**EP-A- 0 845 819        JP-A- 2000 058 884**
**US-A1- 2004 042 520    US-A1- 2004 161 009**

• **MAULINI R ET AL: "CONTINUOUS-WAVE OPERATION OF A BROADLY TUNABLE THERMOELECTRICALLY COOLED EXTERNAL CAVITY QUANTUM-CASCADE LASER" OPTICS LETTERS, OSA, OPTICAL SOCIETY OF AMERICA, WASHINGTON, DC, US, vol. 30, no. 19, 1 octobre 2005 (2005-10-01), pages 2584-2586, XP001235357 ISSN: 0146-9592 cité dans la demande**
• **LUO G P ET AL: "Grating-tuned external-cavity quantum-cascade semiconductor lasers" APPLIED PHYSICS LETTERS, AIP, AMERICAN INSTITUTE OF PHYSICS, MELVILLE, NY, US, vol. 78, no. 19, 7 mai 2001 (2001-05-07), pages 2834-2836, XP012027922 ISSN: 0003-6951**
• **VANYAKIN A V ET AL: "iNTERFERENCE OPTICS FOR LASERS AND PARAMETRIC OSCILLATORS EMITTING IN THE MIDDLE-IR RANGE" QUANTUM ELECTRONICS, vol. 27, no. 2, février 1997 (1997-02), pages 137-139, XP009083667 MOSKVA, RUSSIA**
• **LI DA-QI, LIU DING-QUAN, ZHANG FENG-SHAN: "Design and fabrication of 6.4-15 micrometer broadband antireflection coatings" JOURNAL OF INFRARED AND MILLIMETER WAVES, vol. 25, no. 2, avril 2006 (2006-04), pages 135-137, XP009083554**

EP 2 100 170 B1

## Description

Domaine technique

L'invention concerne un amplificateur laser à cascades quantiques qui comporte une face de sortie sur laquelle est appliqué un revêtement anti-réfléchissant.

L'invention concerne plus particulièrement un amplificateur laser à cascades quantiques, qui est susceptible d'émettre un rayonnement laser infrarouge selon le préambule de la revendication 1.

Etat de la technique

Les lasers du type à cascades quantiques sont déjà connus de l'état de la technique. Un exemple d'un laser à cascades quantiques est notamment divulgué en détail dans le document EP-A1-1.195.865.

Ce type de laser comporte généralement un amplificateur semi-conducteur, tel qu'une puce ou une diode laser, qui est associé à une cavité de résonance, dite de Fabry-Pérot.

Lorsqu'un courant électrique lui est appliqué, l'amplificateur laser émet un rayonnement laser. La cavité de résonance comporte un premier moyen pour réfléchir au moins en partie le rayonnement laser en direction d'un deuxième moyen de réflexion en passant à travers l'amplificateur laser. Le deuxième moyen de réflexion réfléchit à nouveau le rayonnement laser en direction du premier moyen de réflexion via l'amplificateur. Le rayonnement laser effectue ainsi des allers retours successifs dans l'amplificateur laser, ce qui provoque l'amplification du rayonnement laser.

Il est connu de réaliser une cavité de Fabry-Pérot interne au laser. Les moyens de réflexion sont alors formés par des faces verticales opposées clivées de l'amplificateur laser dont l'une au moins forme la face de sortie du rayonnement laser.

Il est aussi connu de réaliser une cavité de Fabry-Pérot externe. Le premier moyen de réflexion, tel qu'un miroir semi-réfléchissant, est alors agencé à l'extérieur du laser, sur la trajectoire du rayonnement laser. Ce miroir permet de réfléchir le rayonnement laser émis par la face de sortie de nouveau vers la face de sortie du laser. Le rayonnement réfléchi entre ainsi dans l'amplificateur laser, puis il est réfléchi par le deuxième moyen de réflexion qui peut être formé par une face réfléchissante clivée opposée à la face de sortie. A chaque passage à travers l'amplificateur laser, le rayonnement laser est ainsi amplifié.

Un tel laser à cascades quantiques émet par exemple un rayonnement laser multimode, un mode correspondant à une longueur d'onde lumineuse composant le rayonnement laser. La longueur d'onde lumineuse de chaque mode est comprise dans l'intervalle des infrarouges proches et moyens, c'est-à-dire entre 3 et 18 $\mu$m.

Il est connu d'utiliser un élément dispersif, par exemple un réseau de diffraction dans un laser à cavité externe afin de filtrer spectralement le rayonnement réfléchi dans l'amplificateur laser pour produire un rayonnement laser globalement monomode.

Pour augmenter la gamme d'accordage d'un tel laser et faciliter un accordage continu, il est préférable que la face de sortie du laser laisse passer entièrement le rayonnement laser sans en réfléchir une partie vers l'intérieur de l'amplificateur laser, ce qui perturberait l'accordage. En effet, l'amplificateur laser formerait alors une cavité parasite interne de résonance comprise dans la cavité externe, provoquant l'apparition de modes parasites.

Or, lorsque la face de sortie n'est pas traitée, la différence entre l'indice de réfraction $n_L$ du milieu amplificateur constituant l'amplificateur laser, qui est par exemple compris entre 3,15 et 3,22, et l'indice de réfraction de l'air qui est égal à 1, provoque la réflexion d'une partie du rayonnement laser incident, la réflectivité de la face de sortie est alors environ de 27%, la réflectivité étant calculée selon la formule $(n_L-1)^2 / (n_L+1)^2$.

Pour résoudre ce problème, il est connu d'appliquer sur la face de sortie du laser un revêtement de matériau anti-réfléchissant dont l'indice de réfraction soit proche d'un indice de réfraction idéal déterminé, par exemple ici 1.8. Cet indice de réfraction idéal est déterminé par le calcul de la réflectivité à une interface entre deux matériaux, ici l'air d'indice de réfraction $n_A=1$ et le substrat d'indice de réfraction $n_L$ et on obtient: $n_D = \sqrt{n_L}$ .

Il est ainsi connu d'appliquer un revêtement d'alumine ($Al_2O_3$) sur la face de sortie du laser. Un tel revêtement ne permet cependant pas de laisser passer la totalité du rayonnement laser infrarouge car son indice de réfraction est trop éloigné de l'indice de réfraction idéal déterminé. Ainsi, un tel revêtement anti-réfléchissant est adapté pour des longueurs d'ondes comprises dans l'infrarouge proche, c'est-à-dire entre 1 et 2 $\mu$m, mais pas pour des longueurs d'ondes comprises dans l'infrarouge moyen, c'est-à-dire entre 3 et 18 $\mu$m.

De tels revêtements sont notamment divulgués dans le document Applied Physics Letters, Volume 78, p.2834, datant de l'année 2001, intitulé "Grating-tuned external-cavity quantum-cascade semiconductors lasers" (G.P. Luo et al.), ainsi que dans le document Optics Letters, Volume 30, p.2584, datant de l'année 2005, et intitulé "Continuous-wave operation of a broadly tunable thermoelectrically cooled external cavity-quanium-cascade laser" (R. Maulini et al.).

On connaît aussi des revêtements réalisés en d'autres matériaux, cependant ces matériaux présentent l'inconvénient de ne pas adhérer correctement aux couches de matériaux constituant l'amplificateur.

Par ailleurs on connaît du document US2004/0042520 A1 un revêtement anti-réfléchissant, qui recouvre une face d'extrémité de sortie de rayonnement d'un laser infrarouge à semi-conducteur, qui présente un indice de réfraction proche d'un indice idéal déterminé de manière à laisser passer la totalité du rayonnement laser à travers la face de sortie, et qui comporte au moins une première strate ayant un premier indice de réfraction inférieur à l'indice idéal déterminé; et au moins une deuxième strate ayant un deuxième indice de réfraction supérieur à l'indice de réfraction idéal déterminé.

Divulgation de l'invention

La présente invention vise donc à résoudre ces problèmes en proposant un laser du type décrit précédemment, caractérisé en ce que la première strate du revêtement anti-réfléchissant est réalisée en fluorure d'yttrium (YF3).

Selon d'autres caractéristiques de l'invention :

- la première strate du revêtement anti-réfléchissant est interposée entre la face de sortie de l'amplificateur laser et la deuxième strate ;
- la deuxième strate est réalisée en séléniure de zinc (ZnSe) ;
- la deuxième strate est réalisée en sulfure de zinc (ZnS) :
- la deuxième strate est réalisée en oxyde de niobium (Nb2O5) ;
- la deuxième strate est réalisée en nitrure de silicium (Si3N4) ;
- l'amplificateur laser émet un rayonnement laser multimode dans l'infrarouge proche et/ou moyen dont les longueurs d'onde sont comprises entre 3 et 18 $\mu$m ;
- les épaisseurs des première et deuxième strates du revêtement anti-réfléchissant sont déterminées en fonction des longueurs d'ondes du rayonnement laser.

Brève description des dessins

D'autres caractéristiques et avantages apparaîtront au cours de la lecture de la description détaillée qui va suivre pour la compréhension de laquelle on se reportera aux dessins annexés parmi lesquels :

- la figure 1 est une vue en coupe qui représente schématiquement un laser à cascades quantiques comportant un amplificateur laser équipé d'un revêtement anti-réfléchissant réalisé selon les enseignements de l'invention ;
- la figure 2 est un graphique qui comporte des courbes représentant l'épaisseur des couches constituant le revêtement anti-réfléchissant réalisé selon les enseignements de l'invention en fonction du nombre d'onde du laser ;
- la figure 3 est un graphique qui comporte des courbes représentant l'épaisseur des couches constituant le revêtement anti-réfléchissant réalisé selon un deuxième mode de réalisation de l'invention en fonction du nombre d'onde du laser:

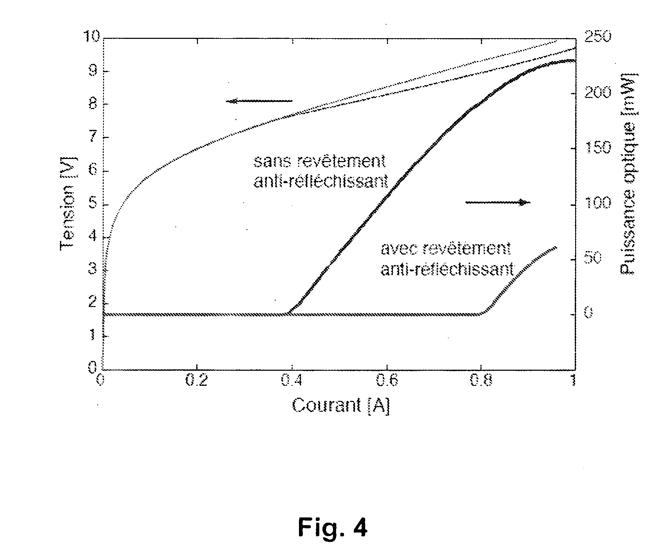

- la figure 4 est un graphique montrant l'effet du revêtement anti-réfléchissant réalisé selon les enseignements de l'invention sur les performances d'un amplificateur laser montrant que la réflectivité de la face de sortie est presque nulle, ce qui a pour effet de fortement diminuer l'amplification laser (augmentation du courant de seuil).

Mode(s) de réalisation de l'invention

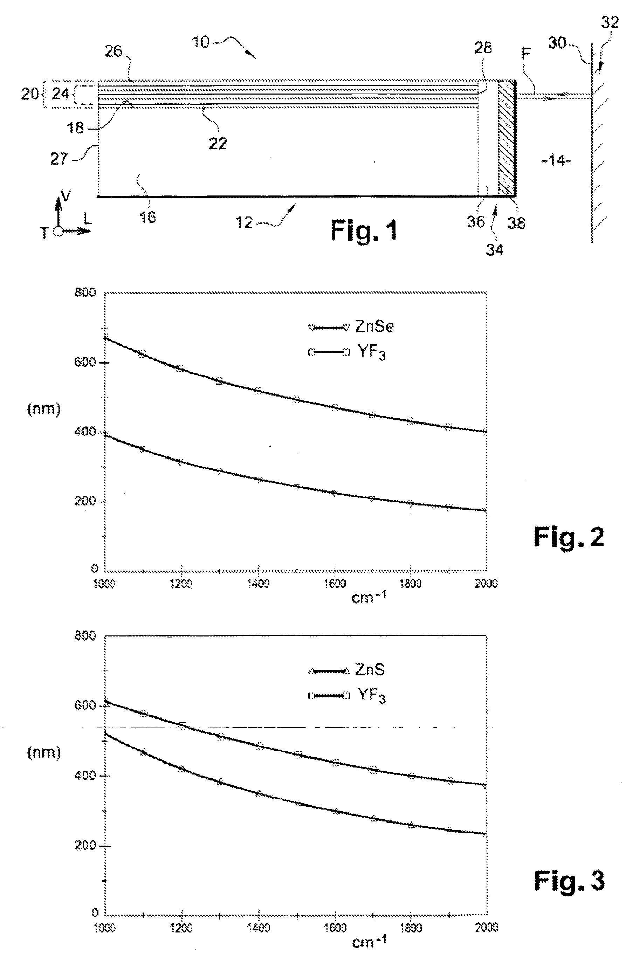

Pour la suite de la description et pour les revendications, on adoptera à titre non limitatif une orientation longitudinale, verticale et transversale indiquée par le trièdre "L,V,T" de la figure 1.

Par la suite, des éléments identiques, analogues ou similaires seront désignés par des mêmes numéros de référence.

On a représenté à la figure 1 un laser à cascade quantique 10 qui comporte un amplificateur laser 12 qui est agencé dans une cavité externe de résonance 14.

L'amplificateur laser 12 se présente ici sous la forme d'un bloc, d'une barrette, d'une diode ou d'une puce horizontale qui est réalisé avec un empilement de différentes couches de matériaux semi-conducteurs.

De manière connue, l'amplificateur laser 12 comporte une couche horizontale inférieure de substrat 16. Sur une face supérieure 18 de ce substrat 16 est agencée une zone active 20 qui est formée par un empilement vertical de couches horizontales de matériaux semi-conducteurs.

Le substrat 16 est susceptible de remplir une fonction d'électrode.

La zone active 20 comporte plus particulièrement, de bas en haut en se reportant à la figure 1, une première couche inférieure 22 de confinement optique, une région de gain 24 et une deuxième couche supérieure de confinement optique 26.

La région de gain 24 est formée d'une pluralité de couches formant successivement des puits quantiques et des barrières quantiques. La région de gain 24 comporte aussi des barrières d'injection. Pour une description plus détaillée d'une telle zone active 20 et de sa composition, on pourra se reporter au document EP-A1-1.195.865 précité.

Lorsque la région de gain 24 est alimentée avec un courant électrique adapté par l'intermédiaire du substrat 16 et des couches de confinement optique 22, 26, un rayonnement laser est créé dans la région de gain 24.

Les couches de confinement optique 22, 26 forment un guide horizontal d'ondes qui est destiné à guider la propagation du rayonnement laser dans la région de gain 24 selon une direction longitudinale.

Toutes les couches de l'amplificateur laser 12 ont une structure monocristalline de même maille dans le plan horizontal afin que l'amplificateur laser 12 ne se délite pas.

Le substrat 16 est réalisé à base d'indium, et plus particulièrement en phosphure d'indium (InP) monocristallin. Le substrat 16 est éventuellement dopé pour améliorer ses propriétés de conduction d'électricité.

Selon une variante non représentée de l'invention, le substrat 16 est réalisé en un alliage monocristallin d'arseniure de Gallium (GaAs).

Les différentes couches de la zone active 20 sont aussi réalisées en matériaux semi-conducteurs monocristallins crûs de manière épitaxiale sur le substrat.

Une telle composition permet de définir une structure cristalline de même maille dans le plan horizontal et identique à celle du substrat 16 en InP. Ainsi, l'amplificateur laser 12 présente une structure cristalline homogène de manière que les différentes couches ne se délitent pas.

De manière connue, certaines couches peuvent être dopées, par exemple avec du silicium (Si).

L'amplificateur laser 12 est délimité longitudinalement par une face verticale transversale d'extrémité arrière 27 et par une face verticale transversale d'extrémité avant 28. Les deux faces avant 28 et arrière 27 sont parallèles. Ces faces 27, 28 sont réalisées par clivage du matériau cristallin formant l'amplificateur laser 12.

La face avant 28 forme une face de sortie du rayonnement laser produit dans la région de gain 24, et la face arrière 27 forme une face de réflexion du rayonnement laser qui est destinée à réfléchir le rayonnement laser vers l'intérieur de la région de gain 24, comme indiqué par les flèches "F" de la figure 1.

Une face verticale transversale semi-réfléchissante 30 d'un miroir externe 32 est agencée en vis-à-vis et en avant de la face de sortie 28 de l'amplificateur laser 12. La face semi-réfléchissante 30 du miroir externe 32 est susceptible de réfléchir au moins une partie du rayonnement laser sortant par la face de sortie 28 de l'amplificateur laser 12.

L'espace qui est compris longitudinalement entre la face semi-réfléchissante 30 du miroir externe 32 et la face arrière de réflexion 27 de l'amplificateur laser 12 forme la cavité externe de résonance 14 de l'amplificateur laser 12.

Un tel laser est susceptible d'émettre un rayonnement laser multimode à des longueurs d'ondes comprises dans l'infrarouge proche et moyen entre 3 et 18 $\mu$m.

Pour la suite de la description, on définit le nombre d'onde d'un mode de rayonnement laser comme étant l'inverse de sa longueur d'onde. Ainsi les nombres d'onde de l'infrarouge moyen sont compris entre 555 et 3333 cm$^{-1}$.

Lorsque la face de sortie 28 de l'amplificateur laser 12 n'est pas traitée, la différence entre l'indice de réfraction "$n_L$" de l'amplificateur laser 12, qui est compris entre 3,15 et 3,22 pour la composition donnée en exemple, et l'indice de réfraction de l'air ambiant "$n_A$", qui est globalement égal à 1, provoque la réflexion d'une partie du rayonnement laser incident, par exemple la réflectivité est d'environ 27%.

L'invention propose d'appliquer sur la face de sortie 28 de l'amplificateur laser 12 un revêtement 34 vertical transversal anti-réfléchissant particulièrement performant susceptible de laisser passer une grande gamme de rayonnement laser infrarouge proche et moyen. Le revêtement anti-réfléchissant 34 présente un indice de réfraction qui est proche d'un indice de réfraction idéal "$n_D$" déterminé de manière à laisser passer la - totalité du rayonnement laser. L'indice de réfraction idéal déterminé "$n_D$" est par exemple égal à 1,8 pour l'amplificateur laser 12 donné en exemple.

Selon les enseignements de l'invention, le revêtement anti-réfléchissant 34 est formé d'une première strate 36 verticale transversale présentant un premier indice de réfraction "$n_1$" qui est inférieur à l'indice de réfraction idéal déterminé "$n_D$", et une deuxième strate 38 verticale transversale présentant un deuxième indice de réfraction "$n_2$" qui est supérieur à l'indice de réfraction idéal déterminé "$n_D$".

La première strate 36 est interposée entre la face de sortie 28 et la deuxième strate 38. Ainsi, la première strate 36 est agencée directement en contact avec la face de sortie 28 de l'amplificateur laser 12.

La première strate 36 du revêtement anti-réfléchissant 34 est réalisée en fluorure d'yttrium (YF$_3$). La première strate 36 présente ainsi un indice de réfraction "$n_1$" qui est inférieur à l'indice de réfraction idéal déterminé "$n_D$". De plus, la première strate 36 du revêtement anti-réfléchissant 34 ainsi réalisée adhère parfaitement à la face de sortie 28 de l'amplificateur laser 12.

La deuxième strate 38 du revêtement anti-réfléchissant 34 est réalisée en séléniure de zinc (ZnSe). La deuxième strate 38 présente ainsi un indice de réfraction "$n_2$" qui est supérieur à l'indice de réfraction idéal déterminé "$n_D$". La deuxième strate 38 ainsi réalisée adhère parfaitement à la première strate 36.

L'indice de réfraction "$n_1, n_2$" de chacune des strates 36, 38 du revêtement anti-réfléchissant 34 est fonction de la longueur d'onde du rayonnement laser considéré. L'épaisseur des strates pour obtenir une réflectivité nulle est déterminée en fonction de la longueur d'onde du rayonnement laser considéré. Le calcul des épaisseurs adaptées aux nombres d'onde du rayonnement laser met en oeuvre un calcul de réflectivité connu qui est par exemple divulgué dans le livre intitulé "Optoélectronique" (E. Rosencher, B. Vinter), édition Masson, Paris, édition de 1998, chapitre 9.

L'épaisseur, en nanomètres, des première 36 et deuxième 38 strates à déposer sur la face de sortie 28 pour obtenir un revêtement anti-réfléchissant 34 de réflectivité nulle pour différents nombres d'onde, en $cm^{-1}$ est indiqué dans le "tableau 1" suivant correspondant à la figure 2 :

Tableau 1

| Nombre d'onde ($cm^{-1}$) | Epaisseur de la première strate 36 en $YF_3$ (nm) | Epaisseur de la deuxième strate 38 en ZnSe (nm) |
|---|---|---|
| 1000 | 674 | 391 |
| 1100 | 624 | 348 |
| 1200 | 583 | 313 |
| 1300 | 547 | 284 |
| 1400 | 517 | 258 |
| 1500 | 490 | 237 |
| 1600 | 467 | 218 |
| 1700 | 445 | 201 |
| 1800 | 426 | 187 |
| 1900 | 408 | 175 |
| 2000 | 391 | 164 |

On remarque ainsi que le revêtement anti-réfléchissant 34 ainsi réalisé est totalement transparent pour un rayonnement laser dont les modes ont un nombre d'onde compris dans l'infrarouge moyen.

Selon une variante non représentée de l'invention, la deuxième strate 38 est réalisée en sulfure de zinc (ZnS). Ce matériau présente en effet des propriétés de réfraction et d'adhérence analogues à celle du séléniure de zinc.

L'épaisseur, en nanomètres, des première 36 et deuxième 38 strates à déposer sur la face de sortie 28 pour obtenir un revêtement anti-réfléchissant 34 de réflectivité nulle pour différents nombres d'onde, en $cm^{-1}$, est indiqué dans le "tableau 2" suivant correspondant à la figure 3 :

Tableau 2

| Nombre d'onde ($cm^{-1}$) | Epaisseur de la première strate 36 en $YF_3$ (nm) | Epaisseur de la deuxième strate 38 en ZnS (nm) |
|---|---|---|
| 1000 | 607 | 507 |
| 1100 | 564 | 453 |
| 1200 | 527 | 408 |
| 1300 | 496 | 370 |
| 1400 | 470 | 338 |
| 1500 | 446 | 310 |
| 1600 | 426 | 286 |
| 1700 | 407 | 265 |
| 1800 | 390 | 247 |
| 1900 | 374 | 231 |
| 2000 | 359 | 217 |

Selon encore une autre variante non représentée de l'invention, d'autres matériaux présentant des propriétés analogues peuvent être employés pour réaliser la deuxième strate 38 du revêtement anti-réfléchissant 34, par exemple du $Nb_2O_5$, ou du $Si_3N_4$.

Les strates 36, 38 du revêtement anti-réfléchissant 34 sont déposées sur la face de sortie 28 de l'amplificateur laser 12 dans une chambre de déposition sous vide par évaporation thermique, par évaporation par canon à électron ou par pulvérisation cathodique par exemple. L'épaisseur de chaque strate 36, 38 du revêtement anti-réfléchissant 34 est mesurée pendant la déposition au moyen d'une balance à quartz.

L'amplificateur laser 12 équipé d'un revêtement anti-réfléchissant 34 réalisé selon les enseignements de l'invention permet d'obtenir une réflectivité nulle pour une gamme élargie de longueurs d'onde du rayonnement laser comprises dans l'infrarouge, et plus particulièrement dans l'infrarouge moyen.

De plus, la première strate 36 réalisée en $YF_3$ est parfaitement adhérente à la face de sortie 28 et elle ne risque pas de se décoller ou de se déliter de la face de sortie 28.

De même, la deuxième strate 38 du revêtement anti-réfléchissant 34 est parfaitement adhérente à la première strate 36.

Selon une variante non représentée de l'invention et par analogie avec la figure 1, la deuxième strate 38 est interposée entre la face de sortie 28 et la première strate 38. Ainsi, la deuxième strate 38 est agencée directement en contact avec la face de sortie 28 de l'amplificateur laser 12.

Les matériaux utilisés pour réaliser la deuxième strate 38 sont aussi parfaitement adhérents à la face de sortie 28.

Selon une variante non représentée de l'invention, le revêtement anti-réfléchissant 38 comporte plus de deux strates. Au moins une première strate est alors réalisée en fluorure d'yttrium, tandis que les deuxièmes strates sont réalisées comme décrit précédemment.

## Revendications

**1.** Amplificateur laser (12) à cascades quantiques, qui est susceptible d'émettre un rayonnement laser infrarouge, et qui comporte :

   - une couche horizontale inférieure d'un substrat (16) en phosphure d'indium (InP) ou en arséniure de gallium (GaAs) ;
   - une zone active (20) qui est formée par un empilement vertical de couches horizontales de matériaux semi-conducteurs crues de manière épitaxiale sur le substrat (16) ;
   - un revêtement vertical anti-réfléchissant (34) qui recouvre une face verticale d'extrémité de sortie (28) du rayonnement laser et qui présente un indice de réfraction proche d'un indice idéal déterminé ($n_D$) de manière à laisser passer la totalité du rayonnement laser à travers la face de sortie, le revêtement anti-réfléchissant (34) comportant :

      - au moins une première strate (36) ayant un premier indice de réfraction ($n_1$) inférieur à l'indice de réfraction idéal déterminé ($n_D$) ;
      - et au moins une deuxième strate (38) ayant un deuxième indice de réfraction ($n_2$) supérieur à l'indice de réfraction idéal déterminé ($n_D$) ;

   **caractérisé en ce que** la première strate (36) du revêtement anti-réfléchissant (34) est réalisée en fluorure d'yttrium ($YF_3$).

**2.** Amplificateur laser (12) selon la revendication précédente, **caractérisé en ce que** la première strate (36) du revêtement anti-réfléchissant (34) est interposée entre la face de sortie (28) de l'amplificateur laser (12) et la deuxième strate (38).

**3.** Amplificateur laser (12) selon l'une quelconque des revendications précédentes, **caractérisé en ce que** la deuxième strate (38) est réalisée en séléniure de zinc (ZnSe).

**4.** Amplificateur laser (12) selon l'une quelconque des revendications 1 ou 2, **caractérisé en ce que** la deuxième strate (38) est réalisée en sulfure de zinc (ZnS).

**5.** Amplificateur laser (12) selon l'une quelconque des revendications 1 ou 2, **caractérisé en ce que** la deuxième strate (38) est réalisée en oxyde de niobium ($Nb_2O_5$).

**6.** Amplificateur laser (12) selon l'une quelconque des revendications 1 ou 2, **caractérisé en ce que** la deuxième strate (38) est réalisée en nitrure de silicium ($Si_3N_4$).

7.  Amplificateur laser (12) selon l'une quelconque des revendications précédentes, **caractérisé en ce que** l'amplificateur laser (12) émet un rayonnement laser multimode dans l'infrarouge proche et/ou moyen dont les longueurs d'onde sont comprises entre 3 et 18 $\mu$m.

8.  Amplificateur laser (12) selon l'une quelconque des revendications précédentes, **caractérisé en ce que** les épaisseurs des première (36) et deuxième (38) strates du revêtement anti-réfléchissant (34) sont déterminées en fonction des longueurs d'ondes du rayonnement laser.

**Claims**

1.  A quantum cascade laser amplifier (12) which is capable of emitting infrared laser radiation, and which includes:

    - a lower horizontal layer of a substrate (16) in indium phosphide (InP) or in gallium arsenide (GaAs);
    - an active area (20) which is formed by a vertical stack or horizontal layers of semiconducting materials grown epitaxially on the substrate (16);
    - an anti-reflection vertical coating (34) which covers a laser radiation output end vertical face (28) and which has a refractive index close to an ideal index ($n_D$) determined so as to let the totality of the laser radiation pass through the output face, the anti-reflection coating (34) including:

        - at least one layer (36) having a first refractive index ($n_1$) smaller than the determined ideal refractive index ($n_D$);
        - and at least one second layer (38) having a second refractive index ($n_2$) larger than the determined ideal refractive index (nc);

    **characterized in that** the first layer (36) of the anti-reflection coating (34) is made in yttrium fluoride ($YF_3$).

2.  The laser amplifier (12) according to the preceding claim, **characterized in that** the first layer (36) of the anti-reflection coating (34) is interposed between the output face (28) of the laser amplifier (12) and the second layer (38).

3.  The laser amplifier (12) according to any of the preceding claims, **characterized in that** the second layer (38) is made in zinc selenide (ZnSe).

4.  The laser amplifier (12) according to any of claims 1 or 2, **characterized in that** the second layer (38) is made in zinc sulfide (ZnS).

5.  The laser amplifier (12) according to any of claims 1 or 2, **characterized in that** the second layer (38) is made in niobium oxide ($Nb_2O_5$).

6.  The laser amplifier (12) according to any of claims 1 or 2, **characterized in that** the second layer (38) is made in silicon nitride ($Si_3N_4$).

7.  The laser amplifier (12) according to any of the preceding claims, **characterized in that** the laser amplifier (12) emits multimode laser radiation in the near and/or mean infrared, the wavelengths of which are comprised between 3 and 18 $\mu$m.

8.  The laser amplifier (12) according to any of the preceding claims, **characterized in that** the thicknesses of the first (36) and second (38) layers of the anti-reflection coating (34) are determined according to the wavelengths of the laser radiation.

**Patentansprüche**

1.  Quantenkaskaden-Laserverstärker (12), der imstande ist, eine Infrarot-Laserstrahlung auszusenden, und der umfasst:

- eine untere horizontale Schicht eines Substrats (16) aus Indiumphosphid (InP) oder aus Galliumarsenid (GaAs),
- eine aktive Zone (20), die von einem vertikalen Stapel horizontaler Schichten aus Halbleitermaterialien gebildet wird, die expitaxial auf dem Substrat (16) gewachsen sind,
- eine vertikale Antireflex-Beschichtung (34), die eine abschließende vertikale Ausgangsfläche (28) der Laserstrahlung bedeckt und die einen Refraktionsindex in der Nähe eines idealen Indexes aufweist, der derart festgelegt ist ($n_D$), dass die gesamte Laserstrahlung durch die Ausgangsfläche durchgelassen wird, wobei die Antireflex-Beschichtung (34) umfasst:

- mindestens eine erste Schicht (36) mit einem ersten Refraktionsindex ($n_1$), der kleiner als der festgelegte ideale Refraktionsindex ($n_D$) ist,
- und mindestens eine zweite Schicht (38) mit einem zweiten Refraktionsindex ($n_2$), der größer als der festgelegte ideale Refraktionsindex ($n_D$) ist,

**dadurch gekennzeichnet, dass** die erste Schicht (36) der Antireflex-Beschichtung aus Yttriumfluorid ($YF_3$) hergestellt ist.

2. Laserverstärker (12) nach vorangehendem Anspruch, **dadurch gekennzeichnet, dass** sich die erste Schicht (36) der Antireflex-Beschichtung (34) zwischen der Ausgangsfläche (28) des Laserverstärkers (12) und der zweiten Schicht (38) befindet.

3. Laserverstärker (12) nach einem der vorangehenden Ansprüche, **dadurch gekennzeichnet, dass** die zweite Schicht (38) aus Zinkselenid (ZnSe) hergestellt ist.

4. Laserverstärker (12) nach einem der Ansprüche 1 oder 2, **dadurch gekennzeichnet, dass** die zweite Schicht (38) aus Zinksulfid (ZnS) hergestellt ist.

5. Laserverstärker (12) nach einem der Ansprüche 1 oder 2, **dadurch gekennzeichnet, dass** die zweite Schicht (38) aus Niob(V)-oxid ($Nb_2O_5$) hergestellt ist.

6. Laserverstärker (12) nach einem der Ansprüche 1 oder 2, **dadurch gekennzeichnet, dass** die zweite Schicht (38) aus Siliciumnitrid ($Si_3N_4$) hergestellt ist.

7. Laserverstärker (12) nach einem der vorangehenden Ansprüche, **dadurch gekennzeichnet, dass** der Laserverstärker (12) eine multimodale Laserstrahlung im nahen und/oder mittleren Infrarotbereich mit Wellenlängen zwischen 3 und 18 $\mu$m inklusive aussendet.

8. Laserverstärker (12) nach einem der vorangehenden Ansprüche, **dadurch gekennzeichnet, dass** die Dicken der ersten (36) und zweiten (38) Schicht der Antireflex-Beschichtung (34) in Abhängigkeit von den Wellenlängen der Laserstrahlung bestimmt werden.

Fig. 1

Fig. 2

Fig. 3

**Fig. 4**

## RÉFÉRENCES CITÉES DANS LA DESCRIPTION

**Documents brevets cités dans la description**

- EP 1195865 A1

- US 20040042520 A1

**Littérature non-brevet citée dans la description**

- **G.P. Luo.** Grating-tuned external-cavity quantum-cascade semiconductors lasers. *Applied Physics Letters,* 2001, vol. 78, 2834

- Continuous-wave operation of a broadly tunable thermoelectrically cooled external cavity-quanium-cascade laser. *Optics Letters,* 2005, vol. 30, 2584
- **E. Rosencher ; B. Vinter.** Optoélectronique. 1998